(19)

**Europäisches Patentamt**
**European Patent Office**
**Office européen des brevets**

(11) **EP 2 831 613 B1**

(12) **EUROPÄISCHE PATENTSCHRIFT**

(45) Veröffentlichungstag und Bekanntmachung des Hinweises auf die Patenterteilung:
**25.05.2016 Patentblatt 2016/21**

(21) Anmeldenummer: **13713736.0**

(22) Anmeldetag: **07.03.2013**

(51) Int Cl.:
*G01R 35/00* (2006.01)      *G01R 19/25* (2006.01)
*G01R 27/32* (2006.01)

(86) Internationale Anmeldenummer:
**PCT/EP2013/000675**

(87) Internationale Veröffentlichungsnummer:
**WO 2013/143650 (03.10.2013 Gazette 2013/40)**

(54) **ZEITBEREICHSMESSVERFAHREN MIT KALIBRIERUNG IM FREQUENZBEREICH**

TIME DOMAIN MEASURING METHOD WITH FREQUENCY DOMAIN CALIBRATION

PROCÉDÉ DE MESURE DANS LE DOMAINE TEMPOREL AVEC CALIBRATION DANS LE DOMAINE FRÉQUENTIEL

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **28.03.2012 DE 102012006314**

(43) Veröffentlichungstag der Anmeldung:
**04.02.2015 Patentblatt 2015/06**

(73) Patentinhaber: **Rosenberger Hochfrequenztechnik GmbH & Co. KG
83413 Fridolfing (DE)**

(72) Erfinder:
• **ZIETZ, Christian
  30177 Hannover (DE)**
• **ARMBRECHT, Gunnar
  84453 Mühldorf (DE)**

(74) Vertreter: **Zeitler Volpert Kandlbinder
Patent- und Rechtsanwälte Partnerschaft mbB
Herrnstrasse 44
80539 München (DE)**

(56) Entgegenhaltungen:
• **EL-DEEB W S ET AL: "Thru-less calibration algorithm and measurement system for on-wafer large-signal characterisation of microwave devices", IET MICROWAVES ANTENNAS & PROPAGATION,, Bd. 4, Nr. 11, 18. November 2010 (2010-11-18), Seiten 1773-1781, XP006036455, ISSN: 1751-8733, DOI: 10.1049/IET-MAP:20090317**

• **HU J ET AL: "Calibrated non-linear vector network measurement without using a multi-harmonic generator", IET MICROWAVES ANTENNAS & PROPAGATION,, Bd. 5, Nr. 5, 11. April 2011 (2011-04-11), Seiten 616-624, XP006038342, ISSN: 1751-8733, DOI: 10.1049/IET-MAP:20100580**
• **FERRERO A ET AL: "A Generalized Time-Domain Waveform Test-Set", MICROWAVE CONFERENCE, 2008. EUMC 2008. 38TH EUROPEAN, IEEE, PISCATAWAY, NJ, USA, 27. Oktober 2008 (2008-10-27), Seiten 749-752, XP031407268, ISBN: 978-2-87487-006-4**
• **MOUHAMAD ABOUCHAHINE ET AL: "Broadband Time-Domain Measurement System for the Characterization of Nonlinear Microwave Devices With Memory", IEEE TRANSACTIONS ON MICROWAVE THEORY AND TECHNIQUES, IEEE SERVICE CENTER, PISCATAWAY, NJ, US, Bd. 58, Nr. 4, 1. April 2010 (2010-04-01), Seiten 1038-1045, XP011304549, ISSN: 0018-9480**
• **D. ROOT ET AL.: "X-Parameter: Das neue Paradigma zur Beschreibung nichtlinearer HF- und Mikrowellenbauelemente", TM - TECHNISCHES MESSEN, Bd. 77, Nr. 7-8, 2010, XP002703955, in der Anmeldung erwähnt**

EP 2 831 613 B1

- DENIS BARATAUD ET AL: "Measurements of Time-Domain Voltage/Current Waveforms at RF and Microwave Frequencies Based on the Use of a Vector Network Analyzer for the Characterization of Nonlinear Devices-Application to High-Efficiency Power Amplifiers and Frequency-Multipliers Optimization", IEEE TRANSACTIONS ON INSTRUMENTATION AND MEASUREMENT, IEEE SERVICE CENTER, PISCATAWAY, NJ, US, Bd. 47, Nr. 5, 1. Oktober 1998 (1998-10-01), XP011024573, ISSN: 0018-9456

- HOLGER HEUERMANN: "Calibration of a Network Analyzer Without a Thru Connection for Nonlinear and Multiport Measurements", IEEE TRANSACTIONS ON MICROWAVE THEORY AND TECHNIQUES, IEEE SERVICE CENTER, PISCATAWAY, NJ, US, Bd. 56, Nr. 11, 1. November 2008 (2008-11-01), Seiten 2505-2510, XP011236944, ISSN: 0018-9480, DOI: 10.1109/TMTT.2008.2005883

## Beschreibung

Die vorliegende Erfindung betrifft ein Verfahren zum Bestimmen von elektrischer Spannung u(t) und/oder elektrischem Strom i(t) eines HF-Signals im Zeitbereich auf einer elektrischen Leitung in einer Kalibrierebene gemäß Anspruch 1. Dabei weist die elektrische Leitung an einem Ende ein erstes Tor und an einem gegenüberliegenden Ende die Kalibrierebene auf, wobei an der Kalibrierebene die elektrische Leitung derart ausgebildet ist, dass an der Kalibrierebene ein Messobjekt elektrisch mit der elektrischen Leitung verbindbar ist, wobei mit mindestens einem Richtkoppler mit zwei Ausgängen ein Anteil eines ersten HF-Signals, welches auf der elektrischen Leitung von dem ersten Tor in Richtung der Kalibrierebene läuft, und ein Anteil eines zweiten HF-Signals, welches auf der elektrischen Leitung von der Kalibrierebene in Richtung des ersten Tores läuft, ausgekoppelt wird, wobei an einem ersten Ausgang des Richtkopplers eine zeitvariable erste Signalgröße $v_1(t)$ des Anteils des ersten HF-Signals und an einem zweiten Ausgang des Richtkopplers eine zeitvariable zweite Signalgröße $v_2(t)$ des Anteils des zweiten HF-Signals erfasst wird, wobei für ein Fehlerzweitor des Richtkopplers mit einer Fehlermatrix $E$

$$E = \begin{pmatrix} e_{00} & e_{01} \\ e_{10} & e_{11} \end{pmatrix}$$

die Fehlerterme $e_{00}$, $e_{01}$, $e_{10}$ und $e_{11}$ in einem ersten Schritt (Kalibrierschritt) in Abhängigkeit von einer Frequenz f bestimmt werden und daraufhin in einem zweiten Schritt (Messschritt) die Signalgrößen $v_1(t)$ und $v_2(t)$ mit einer ersten mathematischen

Operation in den Frequenzraum als Wellengrößen $V_1(f)$ und $V_2(f)$ überführt werden, wobei aus den Wellengrößen $V_1(f)$ und $V_2(f)$ mittels der Fehlerterme $e_{00}$, $e_{01}$, $e_{10}$ und $e_{11}$ absolute Wellengrößen $a_1$ und $b_1$ im Frequenzraum in der Kalibrierebene (14) berechnet werden, wobei die berechneten absoluten Wellengrößen $a_1$ und $b_1$ mittels einer zweiten mathematischen Operation in die elektrische. Spannung u(t) und/oder den elektrischen Strom i(t) des HF-Signals im Zeitbereich an der Kalibrierebene (14) umgerechnet werden.

Zu den wichtigsten Messaufgaben der Hochfrequenz- und Mikrowellentechnik gehört die Messung von Reflexionsfaktoren oder allgemein - bei Mehrtoren - die Messung von Streuparametern. Durch die Streuparameter wird das linear beschreibbare Netzwerkverhalten eines Testobjektes charakterisiert. Häufig interessiert man sich nicht nur für die Streuparameter bei einer einzigen Messfrequenz, sondern für deren Frequenzabhängigkeit über ein endlich breites Messband. Das zugehörige Messverfahren bezeichnet man als Netzwerkanalyse. Je nach der Bedeutung der Phaseninformation bei der jeweiligen Messaufgabe kann man die Streuparameter entweder nur dem Betrage nach oder auch komplex messen. Im ersten Fall spricht man von skalarer, im zweiten Fall von vektorieller Netzwerkanalyse. Je nach Verfahren, Torzahl und Messfrequenzbereich ist der Netzwerkanalysator ein mehr oder weniger aufwendiges System aus Testsignalquelle und Empfängern, die nach dem Homodyn- oder dem Heterodynprinzip arbeiten. Weil die Messsignale durch Leitungen und sonstige Komponenten mit unbekannten und nichtidealen Eigenschaften zum Messobjekt und wieder zurückgeführt werden müssen, treten bei der Netzwerkanalyse neben zufälligen Fehlern auch systematische Fehler auf. Durch Kalibriermessungen, deren Ziel die Bestimmung möglichst vieler der unbekannten Parameter der Messeinrichtung ist, können die systematischen Fehler in gewissen Grenzen rückgängig gemacht werden. Es existieren hier sehr viele Verfahren und Strategien, die sich im Umfang des Fehlermodells und damit in Aufwand und Leistungsfähigkeit erheblich unterscheiden. (Uwe Siart; "Kalibrierung von Netzwerkanalysatoren"; 4. Januar 2012 (Version 1.51); http://www.siart.de/lehre/nwa.pdf)

Jedoch beschreiben derart kalibriert gemessene Streuparameter nur lineare, zeitinvariante Testobjekte vollständig. Eine Erweiterung der Streuparameter auf nichtlineare Testobjekte stellen die X-Parameter (D. Root et al: "X-Parameter: Das neue Paradigma zur Beschreibung nichtlinearer HF- und Mikrowellenbauelemente". In: tm - Technisches Messen Nr. 7-8, Vol. 77, 2010) dar, die ebenfalls über der Frequenz definiert sind. Allerdings lässt sich jedes Testobjekt auch durch Messung der Ströme und Spannungen respektive der absoluten Wellengrößen an seinen Toren im Zeitbereich beschreiben. Die Messung im Zeitbereich erfasst inhärent sämtliche bspw. durch die Nichtlinearität hervorgerufenen weiteren Spektralanteile sowie die zeitliche Veränderung des Testobjekts oder dessen Eingangssignals. Auch eine derartige Zeitbereichsmessung bedarf der Kalibrierung. Zur Messung absoluter Größen können allerdings die oben genannten Kalibrierverfahren nicht unverändert angewendet werden, da sie nur die Bestimmung relativer Größen (Streuparameter) erlauben.

In El-Deeb W.S. et al: "Thru-less calibration algorithm and measurement system for on-wafer large-signal characterisation of microwave devices", IET MICROWAVES ANTENNAS & PROPAGATION, Bd. 4, Nr. 11, 18. November 2010, Seiten 1773-1781, wird ein Kalibrationsverfahren zur Bestimmung der Wellenformen von elektrischer Spannung und/oder elektrischem Strom eines HF-Signals bei Großsignalmessungen im Zeitbereich offenbart.

Auch in Hu J. et al: "Calibrated non-linear vector network measurement without using a multi-harmonic generator", IET MICROWAVES ANTENNAS & PROPAGATION, Bd. 5, Nr. 5, 11. April 2011, Seiten 616-624, wird ein entsprechendes Kalibrationsverfahren zum Bestimmen eines HF-Signals im Zeitbereich offenbart.

Aus der WO 03/048791 A2 ist ein Hochfrequenz-Schaltungsanalysator bekannt, mit dem Verstärkerschaltungen getestet werden. Ein Mikrowellen-Transition-Analysator (MTA) mit zwei Eingängen misst über Signalpfade und Ports im Zeitbereich zwei unabhängige Signalwellenformen, wie beispielsweise hinlaufende und rücklaufende Welle, bei angeschlossener, zu prüfender Verstärkerschaltung. Die gemessenen Wellen werden mittels Kalibrierdaten nachbearbeitet, um den Einfluss des Messsystems auf die Wellen zwischen den Ports der Verstärkerschaltung und den Eingangsports des MTA zu kompensieren. Zum Bestimmen der Kalibrierdaten wird ebenfalls der MTA verwendet, welcher Signale im Zeitbereich bei angeschlossenen Kalibrierstandards misst. Diese Signale im Zeitbereich werden mittels FFT in den Frequenzbereich umgesetzt und anschließend werden die Kalibriedaten bestimmt. Da nur im Zeitbereich periodische Signale gemessen werden sollen, werden die Signale vor der Messung in Niederfrequente Signale umgewandelt.

Der Erfindung liegt die Aufgabe zugrunde, ein verbessertes Messverfahren für hochfrequente Ströme und Spannungen respektive absolute Wellengrößen im Zeitbereich zu entwickeln.

Diese Aufgabe wird erfindungsgemäß durch ein Verfahren der o.g. Art mit den in Anspruch 1 gekennzeichneten Merkmalen gelöst. Vorteilhafte Ausgestaltungen der Erfindung sind in den weiteren Ansprüchen beschrieben.

Bei einem Verfahren der o.g. Art ist es erfindungsgemäß vorgesehen, dass dass zur Bestimmung der ersten Fehlerterme $e_{00}$, $e_{01}$, $e_{10}$ und $e_{11}$ jeweils das erste Tor, der Signaleingang des Richtkopplers samt Zuleitung, der erste Ausgang des Richtkopplers und der zweite Ausgang des Richtkopplers mit einer Kalibriervorrichtung elektrisch verbunden werden und dass zum Messen der zeitvariablen ersten Signalgröße $v_1(t)$ und der zeitvariablen zweiten Signalgröße $v_2(t)$ jeweils der Signaleingang, der erste Ausgang des Richtkopplers und der zweite Ausgang des Richtkopplers von der Kalibriervorrichtung getrennt und mit einer Zeitbereichsmessvorrichtung elektrisch verbunden werden, wobei als Kalibriervorrichtung ein VNA (Vektorieller Netzwerk Analysator) mit einem ersten VNA-Tor, einem zweiten VNA-Tor und einem dritten VNA-Tor verwendet wird, wobei eine über den ersten Ausgang des Richtkopplers ausgekoppelte Wellengröße $a_2$ des Anteils des ersten HF-Signals an dem mit dem ersten Ausgang elektrisch verbundenen zweiten VNA-Tor und eine über den zweiten Ausgang des Richtkopplers ausgekoppelte Wellengröße $b_2$ des Anteils des zweiten HF-Signals an dem mit dem zweiten Ausgang elektrisch verbundenen dritten VNA-Tor des Netzwerkanalysators gemessen werden, wobei für ein Fehlerzweitor zwischen dem ersten Tor der Zuleitung, welches mit dem ersten Tor des VNA verbunden ist, und der Kalibrierebene mit einer zweiten Fehlermatrix $I$

$$I = \begin{pmatrix} i_{00} & i_{01} \\ i_{10} & i_{11} \end{pmatrix}$$

die zweiten Fehlerterme $i_{00}$, $i_{01} \cdot i_{10}$ und $i_{11}$ bestimmt und aus diesen die ersten Fehlerterme $e_{00}$, $e_{01} e_{10}$ und $e_{11}$ bestimmt werden, wobei die ersten Fehlerterme $e_{00}$, $e_{01} \cdot e_{10}$ und $e_{11}$ sowie die zweiten Fehlerterme $i_{00}$, $i_{01} \cdot i_{10}$ und $i_{11}$ aus Streuparametern $S_{11,K}$, $S_{21,K}$ und $S_{31,K}/S_{21,K}$ einer Streumatrix $S$ für das erste Tor der elektrischen Zuleitung zum Signaleingang des Richtkopplers, den ersten Ausgang des Richtkopplers und den zweiten Ausgang des Richtkopplers und jeweils einem an der Kalibrierebene elektrisch angeschlossenen Kalibrierstandard K, wobei K gleich O, S oder M ist und jeweils für einen Kalibrierstandard vom Typ O (Open), S (Short) oder M (Match) steht, gemäß den Formeln

$$i_{00} = S_{11,M}, \tag{4}$$

$$e_{00} = \frac{S_{31,M}}{S_{21,M}}, \tag{5}$$

$$i_{10} \cdot i_{01} = \frac{(\Gamma_O - \Gamma_S)(S_{11,O} - S_{11,M})(S_{11,S} - S_{11,M})}{\Gamma_O \Gamma_S (S_{11,O} - S_{11,S})} \tag{6}$$

$$e_{10} \cdot e_{01} = \frac{(\Gamma_O - \Gamma_S)\left(\frac{S_{31,O}}{S_{21,O}} - \frac{S_{31,M}}{S_{21,M}}\right)\left(\frac{S_{31,S}}{S_{21,S}} - \frac{S_{31,M}}{S_{21,M}}\right)}{\Gamma_O \Gamma_S \left(\frac{S_{31,O}}{S_{21,O}} - \frac{S_{31,S}}{S_{21,S}}\right)} \tag{7}$$

$$i_{11} = \frac{\Gamma_S(S_{11,O} - S_{11,M}) - \Gamma_O(S_{11,S} - S_{11,M})}{\Gamma_O \Gamma_S(S_{11,O} - S_{11,S})} \qquad (8)$$

$$e_{11} = \frac{\Gamma_S\left(\frac{S_{31,O}}{S_{21,O}} - \frac{S_{31,M}}{S_{21,M}}\right) - \Gamma_O\left(\frac{S_{31,S}}{S_{21,S}} - \frac{S_{31,M}}{S_{21,M}}\right)}{\Gamma_O \Gamma_S\left(\frac{S_{31,O}}{S_{21,O}} - \frac{S_{31,S}}{S_{21,S}}\right)} \qquad (9)$$

berechnet werden, wobei $\Gamma_0$ ein bekannter Reflexionsfaktor des Kalibrierstandards Open und $\Gamma_S$ ein bekannter Reflexionsfaktor des Kalibrierstandards Short ist, wobei die Streuparameter $S_{11,K}$, $S_{21,K}$ und $S_{31,K}/S_{21,K}$ gemäß den Formeln

$$S_{11,K} = \frac{b_0}{a_0} \qquad (1)$$

$$S_{21,K} = \frac{a_2}{a_0} \qquad (2)$$

$$\frac{S_{31,K}}{S_{21,K}} = \frac{b_2}{a_2} \qquad (3)$$

aus Messungen mit dem VNA (26) von einer Wellengröße $a_0$ des ersten HF-Signals am ersten Tor (12), einer Weitengröße $b_0$ des zweiten HF-Signals am ersten Tor (12), der Wellengröße $a_2$ des Anteils des ersten HF-Signals am ersten Ausgang (20) des Richtkopplers (18) und der Wellengröße $b_2$ des Anteils des zweiten HF-Signals am zweiten Ausgang (22) des Richtkopplers (18) bestimmt werden, wobei jeweils der Kalibrierstandard K (16) an der Kalibrierebene (14) elektrisch angeschlossen ist, wobei die Wellengrößen $a_1$ und $b_1$ gemäß folgender Formeln bestimmt werden

$$a_1 = \frac{e_{10}a_2}{1 - e_{11}\Gamma_{DUT}} \qquad (13)$$

$$b_1 = \frac{b_2 - e_{00}a_2}{e_{01}} \qquad (15)$$

wobei

$$a_2 = \frac{V_1}{\sqrt{Z_1}} \qquad (18)$$

$$b_2 = \frac{V_2}{\sqrt{Z_1}} \qquad (19)$$

$$\Gamma_{DUT} = \frac{\frac{b_2}{a_2} - e_{00}}{e_{10} \cdot e_{01} + e_{11}\left(\frac{b_2}{a_2} - e_{00}\right)} \cdot \qquad (10)$$

$$e_{10} = i_{10} \cdot \frac{a_0}{a_2} \cdot \frac{1 - e_{11}\Gamma_{DUT}}{1 - i_{11}\Gamma_{DUT}} \qquad (14)$$

ist, wobei $\Gamma_{DUT}$ der Reflexionsfaktor des an der Kalibrierebene (14) angeschlossenen, zu testenden Prüflings (16) (DUT - Device Under Test) und $Z_1$ die Impedanz am ersten und zweiten Ausgang (20, 22) des Richtkopplers (18) ist.

Dies hat den Vorteil, dass eine kalibrierte Messung von elektrischen Spannungen und Strömen im Zeitbereich zur Verfügung steht, so dass die Phasenlage aller spektralen Komponenten im Ausgangssignal automatisch erhalten bleibt. Trotzdem kann die Kalibrierung mit monofrequenten Signalen im Frequenzbereich durchgeführt werden. Es wird ein besonders hochauflösendes Messverfahren mit großem Dynamikbereich erzielt, wobei eine besonders einfache, schnelle und genaue Kalibration möglich ist. Weiterhin ist eine eindeutige separate Bestimmung aller ersten Fehlerterme $e_{00}$, $e_{01}$, $e_{10}$ und $e_{11}$ möglich.

Einen besonders einfachen Messaufbau mit kostengünstigen elektronischen Komponenten erzielt man dadurch, dass die Signalgrößen $v_1(t)$ und $v_2(t)$ jeweils eine elektrische Spannung oder ein elektrischer Strom sind.

Eine besonders schnelle und gleichzeitig genaue Umsetzung zwischen Frequenzraum und Zeitbereich, die mit geringem Rechenaufwand durchgeführt werden kann, erzielt man dadurch, dass die erste mathematische Operation eine FFT (Fast Fourier Transformation) ist gemäß

$$\{V_1(l \cdot \Delta f)\} = FFT\{v_1(k \cdot \Delta t)\} \qquad (16)$$

$$\{V_2(l \cdot \Delta f)\} = FFT\{v_2(k \cdot \Delta t)\} \qquad (17)$$

mit $k = 0,1,..., N - 1$ und

$$l = 0,1, \dots, \frac{N-1}{2},$$

wobei N eine Anzahl von Datenpunkten ist, wobei $\Delta f$ eine Frequenzschrittweite mit $\Delta f = 2f_{max}/(N - 1)$ ist, wobei $\Delta t$ eine zeitlichen Schrittweite mit $\Delta t = 0{,}5/f_{max}$ ist, wobei $f_{max}$ die maximale Frequenz bezeichnet, für die Kalibrierdaten vorliegen, wobei die zweite mathematische Operation eine inverse FFT (IFFT-Inverse Fast Fourier Transformation) gemäß

$$\{u(k \cdot \Delta t)\} = IFFT\{\sqrt{Z_0}(a_1(l \cdot \Delta f) + b_1(l \cdot \Delta f))\}, \qquad (20)$$

$$\{i(k \cdot \Delta t)\} = IFFT\left\{\left(\sqrt{Z_0}\right)^{-1}(a_1(l \cdot \Delta f) - b_1(l \cdot \Delta f))\right\}. \qquad (21)$$

ist, wobei $Z_0$ eine Impedanz in der Kalibrierebene ist.

Einen besonders einfachen und funktionssicheren Messaufbau erzielt man dadurch, dass als Zeitbereichsmessvorrichtung ein Oszilloskop verwendet wird, beispielsweise ein digitales Oszilloskop, welches zur Zeit- und Wertbereichsquantisierung des Signals verwendet werden kann.

Die Erfindung schlägt folglich ein Kalibrierverfahren vor, bei dem ausgenutzt wird, dass die reine Kalibrierung linear und zeitinvariant ist und somit im Frequenzbereich vorgenommen werden kann. Dies ermöglicht die Nutzung der hohen Dynamik eines vektoriellen Netzwerkanalysators

Die Erfindung wird im Folgenden anhand der Zeichnung näher erläutert. Diese zeigt in:

Fig. 1     eine schematische Darstellung eines Messaufbaus zum Ausführen eines Kalibrierschrittes im Frequenzbereich des erfindungsgemäßen Verfahrens,

Fig. 2     ein Signalflussdiagramm für ein Fehlerzweitor mit der zweiten Fehlermatrix *I* zwischen einem ersten Tor und einer Kalibrierebene einer elektrischen Leitung für den Messaufbau gemäß Fig. 1,

Fig. 3     ein Signalflussdiagramm für ein Fehlerzweitor mit der ersten Fehlermatrix *E* zwischen Ausgängen eines Richtkopplers und einer Kalibrierebene einer elektrischen Leitung für den Messaufbau gemäß Fig. 1,

Fig. 4     eine schematische Darstellung eines Messaufbaus zum Ausführen eines Messschrittes im Zeitbereich des erfindungsgemäßen Verfahrens,

Fig. 5    eine graphische Darstellung von im Kalibrierschritt des erfindungsgemäßen Verfahrens exemplarisch bestimmten ersten Fehlerkoeffizienten $e_{00}$, $e_{01}$, $e_{10}$ und $e_{11}$ der ersten Fehlermatrix $E$ in Abhängigkeit von einer Frequenz f,

Fig. 6    eine graphische Darstellung einer in der Kalibrierebene mit dem erfindungsgemäßen Verfahren bestimmten elektrischen Spannung u(t) sowie einer direkten Messung der elektrischen Spannung $u_M(t)$ für ein am ersten Tor eingespeistes HF-Signal in Form eines Pulses,

Fig. 7    eine graphische Darstellung einer in der Kalibrierebene mit dem erfindungsgemäßen Verfahren bestimmten elektrischen Spannung u(t) sowie einer direkten Messung der elektrischen Spannung $u_M(t)$ für ein am ersten Tor eingespeistes HF-Signal mit Oberwellen,

Fig. 8    eine graphische Darstellung einer in der Kalibrierebene mit dem erfindungsgemäßen Verfahren bestimmten elektrischen Spannung u(t) sowie einer direkten Messung der elektrischen Spannung $u_M(t)$ für ein am ersten Tor eingespeistes HF-Signal in Form eines Rauschens,

Fig. 9    eine graphische Darstellung einer Differenz der elektrischen Spannung $\Delta U$ zwischen der mit dem erfindungsgemäßen Verfahren bestimmten elektrischen Spannung u(t) sowie der direkten Messung der elektrischen Spannung $u_M(t)$ gemäß Fig. 8, also für das am ersten Tor eingespeiste HF-Signal in Form eines Rauschens und

Fig. 10   eine graphische Darstellung von mit dem Messaufbau gemäß Fig. 4 gemessenen elektrischen Spannungen $v_1(t)$ und $v_2(t)$.

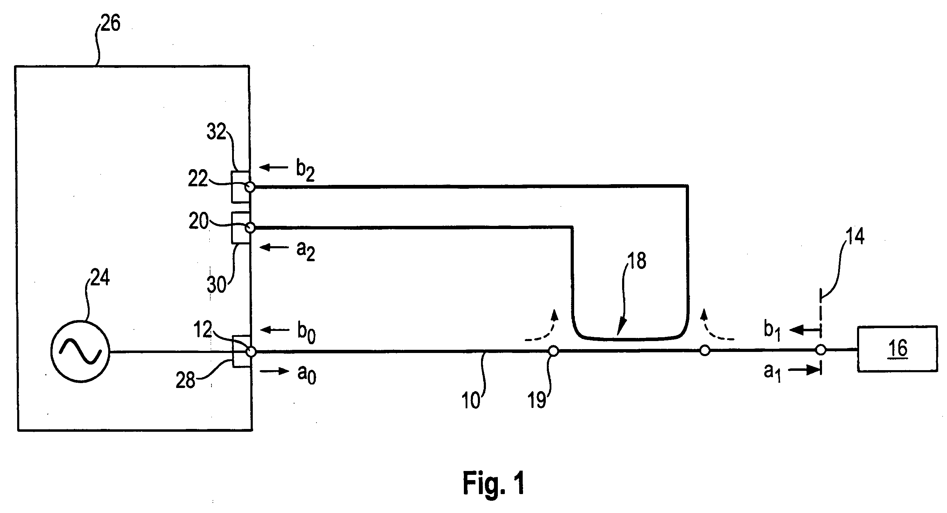

In Fig. 1 ist schematisch eine Anordnung zum Durchführen des erfindungsgemäßen Verfahrens dargestellt. Diese Anordnung weist einen Richtkoppler 18 mit einem Signaleingang 19 auf, der über eine Zuleitung 10 mit einem Tor 12 verbunden ist.

Das andere Ende des Richtkopplers weist eine Kalibrierebene 14 auf. Die Kalibrierebene 14 ist derart ausgebildet, dass an der Kalibrierebene 14 ein Messobjekt (DUT - <u>D</u>evice <u>U</u>nder <u>T</u>est) 16 elektrisch verbindbar ist. Dieses DUT 16 ist beispielsweise ein Kalibrierstandard oder eine zu testende elektronische Schaltung oder ein elektronisches Bauelement. Mit dem Richtkoppler 18 mit zwei Ausgängen 20, 22 wird ein Anteil eines ersten HF-Signals, welches innerhalb des Richtkopplers 18 vom Signaleingang 19 in Richtung der Kalibrierebene 14 läuft, und ein Anteil eines zweiten HF-Signals, welches innerhalb des Richtkopplers 18 von der Kalibrierebene 14 in Richtung des Signaleingangs 19 läuft, ausgekoppelt. Als Richtkoppler 18 ist jedes Bauelement geeignet, welches eine Richtschärfe aufweist, d.h. eine Unterscheidung des Anteils des ersten HF-Signals und des Anteils des zweiten HF-Signals ermöglicht. Am ersten Tor 12 der Zuleitung 10 wird mittels eines Signalgenerators 24 ein Signal eingespeist.

Fig. 1 zeigt schematisch einen Messaufbau zur Durchführung einer Kalibrierung der Anordnung aus Zuleitung 10 zwischen dem Tor 12 und dem Signaleingang 19, Richtkoppler 18 und Ausgängen 20, 22 mit einem vektoriellen Netzwerkanalysator (VNA) 26 mit einem ersten VNA-Tor 28, einem zweiten VNA-Tor 30 und einem dritten VNA-Tor 32. Dabei werden folgende Wellengrößen eingeführt: $a_0$ und $b_0$ bezeichnen die Wellen am speisenden ersten Tor 12 der Zuleitung 10, welches mit einem entsprechenden ersten Tor des Netzwerkanalysators 26 elektrisch verbunden ist. $a_1$ und $b_1$ bezeichnen die Wellengrößen in der Kalibrierebene 14. Die Wellengrößen $a_2$ und $b_2$ sind über den Richtkoppler 18 ausgekoppelte Größen, die an dem zweiten VNA-Tore 30 und dem dritten VNA-Tor 32 des Netzwerkanalysators 26, die mit dem ersten Ausgang 20 und dem zweiten Ausgang 22 des Richtkopplers 18 elektrisch verbunden sind, gemessen werden. Hierbei wird davon ausgegangen, dass diese Tore 30, 32 ideal angepasst sind, also keine Reflexion dieser Wellen stattfindet. Im Rahmen der Kalibrierung soll der Zusammenhang zwischen $a_1$, $b_1$ sowie den Größen $a_2$, $b_2$ bestimmt werden. Der VNA 26 ist bereits an seinen Toren 28, 30, 32 kalibriert, z.B. unter Verwendung des UOSM-Verfahrens (Unknown, Open, Short, Match, auch bekannt als SOLR). Somit können die Verhältnisse der Wellengrößen direkt als Streuparameter gemessen werden, insbesondere

$$S_{11} = \frac{b_0}{a_0}, \qquad\qquad (1)$$

$$S_{21} = \frac{a_2}{a_0}, \qquad\qquad (2)$$

$$\frac{S_{31}}{S_{21}} = \frac{b_2}{a_2}. \qquad\qquad (3)$$

Es werden nun Messungen der genannten Streuparameter über den gewünschten Frequenzbereich durchgeführt, während drei verschiedene Kalibrierstandards 16 (OSM: Open, Short, Match) als DUT (Device Under Test) für bekannte Reflexionsfaktoren $\Gamma_{DUT}$ in der Kalibrierebene sorgen.

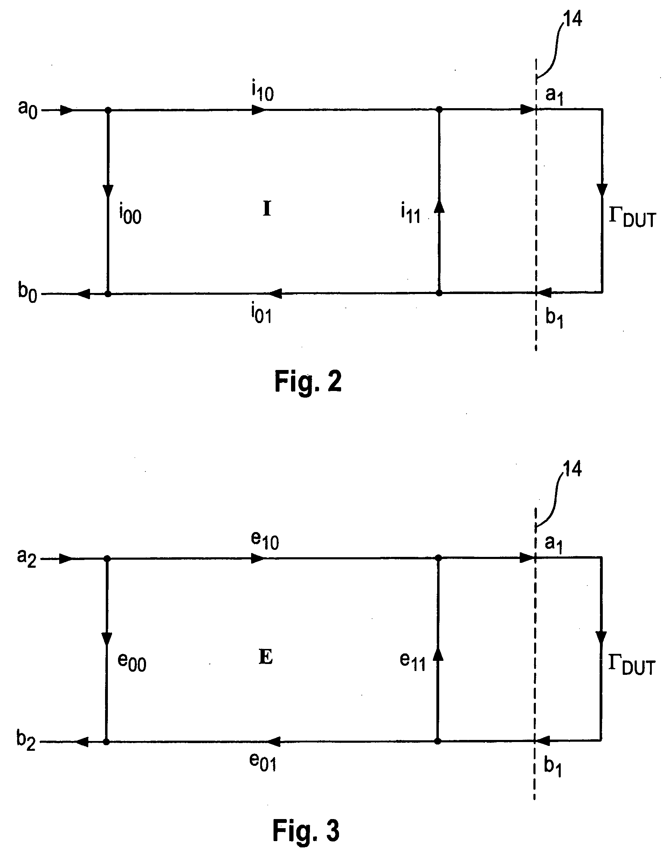

Die Eigenschaften des Richtkopplers 18 werden als ein Fehlerzweitor betrachtet, das zwischen dem Messobjekt (DUT) 16 bzw. der Kalibrierebene 14 und dem dann idealen Richtkoppler 18 angeordnet ist. Fig. 3 zeigt das entsprechende Signalflussdiagramm für dieses Fehlerzweitor. Fig. 2 zeigt das entsprechende Signalflussdiagramm für das zweite Fehlerzweitor der in Fig. 1 dargestellten Anordnung zwischen dem Tor 12 der Zuleitung 10 und der Kalibrierebene 14. Im Zuge einer Kalibration werden die einzelnen Fehlerparameter bestimmt und zur rechnerischen Korrektur der Messwerte verwendet. Das Fehlerzweitor gemäß Fig. 3 mit der erstein Fehlermatrix $E$ stellt ein zwischen dem eigentlichen Messobjekt und dem Messresultat geschaltetes Zweitor mit den vier unabhängigen Parametern $e_{00}$, $e_{10}$, $e_{01}$ und $e_{11}$ dar, wobei es sich hierbei um komplexe Parameter handelt, die frequenzabhängig sind. Daher müssen für jeden gewünschten Frequenzwert diese vier Parameter des Fehlerzweitors ermittelt werden. Hierzu sind mindestens drei unabhängige Messungen an sogenannten Kalibierstandards 16 notwendig. Eine häufig eingesetzte Kalibrationsmethode ist die sogenannte OSL-Kalibration (Open, Short, Load). Die Berechnung der komplexen Parameter $e_{00}$, $e_{10}e_{01}$ und $e_{11}$ aus den Kalibrationsmessungen ist beispielsweise in "Hochfrequenztechnik: Lineare Modelle" von G Zimmer; Springer-Verlag Berlin Heidelberg New York; 2000; ISBN 3 540 66716 4 beschrieben. Diese drei Parameter erlauben bereits die Bestimmung des Reflexionsfaktors eines unbekannten DUTs, jedoch nicht die erfindungsgemäße Bestimmung absoluter Wellengrößen. Zur Zerlegung des Produkts $e_{10}e_{01}$ in seine Faktoren $e_{10}$, $e_{01}$, wird daher wie im folgenden Abschnitt beschrieben vorgegangen.

Der Messaufbau gemäß Fig. 1 lässt sich daher in zwei unabhängige Fehlerzweitore zerlegen Die Fig. 2 zeigt ein Signal-Flussdiagramm eines ersten Fehlerzweitores mit einer zweiten Fehlermatrix $I$

$$I = \begin{pmatrix} i_{00} & i_{01} \\ i_{10} & i_{11} \end{pmatrix},$$

zwischen dem ersten Tor 12 der elektrischen Signalleitung 10 bzw. dem ersten VNA-ein Signal-Flussdiagramm eines zweiten Fehlerzweitores mit der ersten Fehlermatrix $E$

$$E = \begin{pmatrix} e_{00} & e_{01} \\ e_{10} & e_{11} \end{pmatrix},$$

das aus einer Viertor-Zweitor-Reduktion (gemäß beispielsweise HIEBEL, Michael: Grundlagen der vektoriellen Netzwerkanalyse. 1. Auflage, München: Rohde & Schwarz GmbH & Co. KG, 2006) resultiert, zwischen dem zweiten und dritten Tor 30, 32 des VNA 26 bzw. dem ersten und zweiten Ausgang 20, 22 des Richtkopplers 18 einerseits sowie dem DUT 16 andererseits. Finales Ziel der Kalibrierung ist die Bestimmung aller vier Komponenten $e_{00}$, $e_{01}$, $e_{10}$, $e_{11}$ der Fehlermatrix $E$, da nur dann die absolute Wellengröße sowie Strom und Spannung bestimmt werden können. Die Vermessung mit OSM-Kalibrierstandards (OSM = Open; Short; Match) ermöglicht die Bestimmung von $(e;i)_{00}$, $(e;i)_{11}$ und $(e;i)_{10} \cdot (e;i)_{01}$ separat für jeden Frequenzpunkt. Bezeichnet man die Reflexionsfaktoren der Standards Open, Short und Match als $\Gamma_0$, $\Gamma_S$ und $\Gamma_M$ und nimmt $\Gamma_M = 0$ (idealer Match) an, so ergibt sich (gemäß HIEBEL, Michael: Grundlagen der vektoriellen Netzwerkanalyse. 1. Auflage, München: Rohde & Schwarz GmbH & Co. KG, 2006) unter Verwendung von (1) bis (3):

$$i_{00} = S_{11,M}, \qquad\qquad (4)$$

$$e_{00} = \frac{S_{31,M}}{S_{21,M}}, \qquad\qquad (5)$$

$$i_{10} \cdot i_{01} = \frac{(\Gamma_O - \Gamma_S)(S_{11,O} - S_{11,M})(S_{11,S} - S_{11,M})}{\Gamma_O \Gamma_S (S_{11,O} - S_{11,S})} \qquad (6)$$

$$e_{10} \cdot e_{01} = \frac{(\Gamma_O - \Gamma_S)\left(\frac{S_{31,O}}{S_{21,O}} - \frac{S_{31,M}}{S_{21,M}}\right)\left(\frac{S_{31,S}}{S_{21,S}} - \frac{S_{31,M}}{S_{21,M}}\right)}{\Gamma_O \Gamma_S \left(\frac{S_{31,O}}{S_{21,O}} - \frac{S_{31,S}}{S_{21,S}}\right)} \qquad (7)$$

$$i_{11} = \frac{\Gamma_S (S_{11,O} - S_{11,M}) - \Gamma_O (S_{11,S} - S_{11,M})}{\Gamma_O \Gamma_S (S_{11,O} - S_{11,S})} \qquad (8)$$

$$e_{11} = \frac{\Gamma_S \left(\frac{S_{31,O}}{S_{21,O}} - \frac{S_{31,M}}{S_{21,M}}\right) - \Gamma_O \left(\frac{S_{31,S}}{S_{21,S}} - \frac{S_{31,M}}{S_{21,M}}\right)}{\Gamma_O \Gamma_S \left(\frac{S_{31,O}}{S_{21,O}} - \frac{S_{31,S}}{S_{21,S}}\right)} \qquad (9)$$

Hierbei bezeichnet $S_{xy,z}$ die Messung des Streuparameters S mit x = 1, 2 oder 3 und y = 1 mit dem Standard Z mit Z = O (Open), M (Match) oder S (Short). Die Kenntnis dieser Terme genügt, um den Reflexionsfaktor eines DUTs 16 in der Kalibrierebene $\Gamma_{DUT} = b_1/a_1$ aus dem Verhältnis der gemessenen Wellengrößen $b_2/a_2$ (vgl. (3)) zu bestimmen. Hierfür gilt:

$$\Gamma_{DUT} = \frac{\frac{b_2}{a_2} - e_{00}}{e_{10} \cdot e_{01} + e_{11}\left(\frac{b_2}{a_2} - e_{00}\right)}. \qquad (10)$$

Für eine Bestimmung der absoluten Wellengrößen $a_1$ und $b_1$ aus $a_2$ und $b_2$ ist jedoch die Zerlegung des Produkts $e_{10} \cdot e_{01}$ in seine Faktoren nötig. Dazu wird zunächst $i_{10} \cdot i_{01}$ zerlegt. Hierbei kann ausgenutzt werden, dass die zweite Fehlermatrix $I$ den Zusammenhang zwischen dem ersten VNA-Tor 28 des VNA 26 und der Kalibrierebene 14 und somit ein reziprokes Zweitor beschreibt, d.h.

$$i_{10} = i_{01} = \pm\sqrt{i_{10} \cdot i_{01}}. \qquad (11)$$

Die Entscheidung bezüglich des korrekten Vorzeichens in (11) ist äquivalent zur korrekten Bestimmung der Phase von $i_{10}$ aus zwei Möglichkeiten. Hierzu wird wie folgt vorgegangen: Die Phase an einem Frequenzpunkt wird als hinreichend genau bekannt vorausgesetzt, um darüber die Vorzeichenentscheidung zu treffen. Dies kann beispielsweise über eine Abschätzung der elektrischen Länge des Aufbaus zwischen dem ersten VNA-Tor 28 des VNA 26 und der Kalibrierebene 14 geschehen.

Es wird weiterhin davon ausgegangen, dass sich die Phase zwischen zwei benachbarten Frequenzpunkten um weniger als 90° ändert. Somit kann auch die korrekte Phase von $i_{10}$ für alle Frequenzpunkte bestimmt werden. Aus den Signal-Flussdiagrammen in den Fig. 2 und 3 können folgende Beziehungen für $a_1$ hergeleitet werden:

$$a_1 = \frac{i_{10} a_0}{1 - i_{11} \Gamma_{DUT}} \qquad (12)$$

$$a_1 = \frac{e_{10} a_2}{1 - e_{11} \Gamma_{DUT}} \qquad (13)$$

Da beide Gleichungen dieselbe Wellengröße beschreiben, ergibt sich daraus

$$e_{10} = i_{10} \cdot \frac{a_0}{a_2} \cdot \frac{1 - e_{11} \Gamma_{DUT}}{1 - i_{11} \Gamma_{DUT}} \qquad (14)$$

Hierbei ist $\frac{a_0}{a_2} = S_{21}^{-1}$, so dass $e_{10}$ und daraus mit (7) auch $e_{01}$ einzeln bestimmt werden können. Mit (10), (13) und der ebenfalls aus dem Signalflussgraphen gemäß Fig. 3 herleitbaren Beziehung ————

$$b_1 = \frac{b_2 - e_{00}a_2}{e_{01}} \tag{15}$$

können nun, nach Bestimmung der vier Koeffizienten der Matrix $E$ aus gemessenen $a_2$ und $b_2$ die absoluten Wellengrößen $a_1$ und $b_1$ in der Kalibrierebene 14 bestimmt werden.

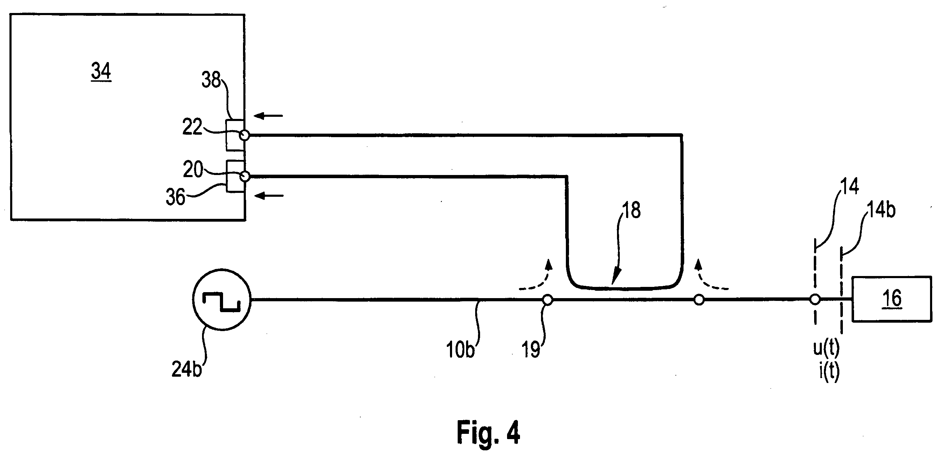

Fig. 4 zeigt den Aufbau zur Messung von Strom i(t) und Spannung u(t) in der vorher festgelegten Kalibrierebene 14 im Zeitbereich, wobei funktionsgleiche Teile mit gleichen Bezugszeichen bezeichnet sind, wie in Fig. 1 und 3, so dass zu deren Erläuterung auf die obige Beschreibung der Fig. 1 und 3 verwiesen wird. Hierbei ist ein Oszilloskop 34 mit den Ausgängen 20 und 22 des Richtkopplers 18 elektrisch verbunden und mit dem Signaleingang 19 ist über eine ggf. geänderte Zuleitung 10b eine beliebige Signalquelle 24b verbunden.

Da durch die Messung im Zeitbereich inhärent die Phaseninformation zwischen allen spektralen Komponenten erhalten bleibt, ist dieser Aufbau nicht auf die Messung monofrequenter oder periodischer Signale beschränkt. Die Ausgänge 20, 22 des Richtkopplers 18 sind mit zwei als $v_1$ 36 bzw. $v_2$ 38 bezeichneten Eingangskanälen des Oszilloskops 34 verbunden. Es wird davon ausgegangen, dass sich der Aufbau zwischen der Kalibrierebene 14 und den Eingängen 36, 38 des Oszilloskops 23 bzw. den Ausgängen 20, 22 des Richtkopplers 18 gegenüber der Kalibrierung gemäß Fig. 1 nicht ändert, damit die gewonnenen Kalibrierkoeffizienten gültig bleiben. Änderungen an der Signalquelle 24b und deren Zuleitung 10b zum Koppler haben hingegen keinen Einfluss auf die Kalibrierung.

Die gemessenen Spannungen werden - ggf. durch Interpolation - als zeitdiskrete Vektoren $\{v_1(k\cdot\Delta t)\}$ bzw. $\{v_2(k\cdot\Delta t)\}$ mit einer zeitlichen Schrittweite $\Delta t = 0{,}5/f_{max}$ dargestellt, wobei $f_{max}$ die maximale Frequenz bezeichnet, für die Kalibrierdaten vorliegen und k = 0,1,...,N-1 ein Laufindex über alle N Datenpunkte ist. Diese Vektoren werden mit Hilfe der schnellen Fourier-Transformation (FFT) in den Frequenzbereich überführt und dann als $v_1$ und $v_2$ bezeichnet:

$$\{V_1(l \cdot \Delta f)\} = FFT\{v_1(k \cdot \Delta t)\} \tag{16}$$

$$\{V_2(l \cdot \Delta f)\} = FFT\{v_2(k \cdot \Delta t)\} \tag{17}$$

mit $k = 0,1,...,N - 1$ *und* $l = 0,1,\ldots,\frac{N-1}{2}$.

Da es sich bei den gemessenen Spannungen um reelle Größen handelt, ist die Betrachtung der Spektralanteile für f≥0 ausreichend. Es ergibt sich eine Frequenzschrittweite $\Delta f = 2f_{max}/(N-1)$. Die Kalibrierkoeffizienten $e_{xy}$ werden durch Interpolation in dasselbe Frequenzraster gebracht. Nimmt man an, dass die Eingänge des Oszilloskops 34 dieselbe Impedanz $Z_1$ aufweisen wie ihre Zuleitung, so dass an dieser Stelle keine Reflexionen auftreten, so bestimmen sich die korrespondieren Wellengrößen für jeden Frequenzpunkt zu:

$$a_2 = \frac{V_1}{\sqrt{Z_1}} \tag{18}$$

$$b_2 = \frac{V_2}{\sqrt{Z_1}} \tag{19}$$

Aus diesen Wellengrößen werden mit Hilfe von (10), (13) sowie (15) die absoluten Wellengrößen $a_1$ und $b_1$ in der Kalibrierebene 14 bestimmt. Weiterhin ist es möglich, durch Deembedding, d.h. bei Kenntnis der Streuparameter der Elemente zwischen der Kalibrierebene 14 und einer weiteren Ebene 14b, die Ebene, bezüglich derer die absoluten Wellengrößen $a_1$ und $b_1$ bestimmt werden, gegenüber der ursprünglichen Kalibrierebene 14 auf die Ebene 14b zu verschieben. (Michael Hiebel: Grundlagen der vektoriellen Netzwerkanalyse. 1. Auflage, München: Rohde & Schwarz GmbH & Co. KG, 2006) Mit Hilfe der inversen FFT kann daraus die zeitdiskrete Darstellung der Spannung u(t) und des Stroms i(t) in der Kalibrierebene 14 respektive der durch Deembedding verschobenen Ebene 14b gewonnen werden, wobei auch hier ausgenutzt wird, dass es sich dabei um reelle Größen handelt:

$$\{u(k \cdot \Delta t)\} = IFFT\left\{\sqrt{Z_0}\left(a_1(l \cdot \Delta f) + b_1(l \cdot \Delta f)\right)\right\}, \qquad (20)$$

$$\{i(k \cdot \Delta t)\} = IFFT\left\{\left(\sqrt{Z_0}\right)^{-1}\left(a_1(l \cdot \Delta f) - b_1(l \cdot \Delta f)\right)\right\}. \qquad (21)$$

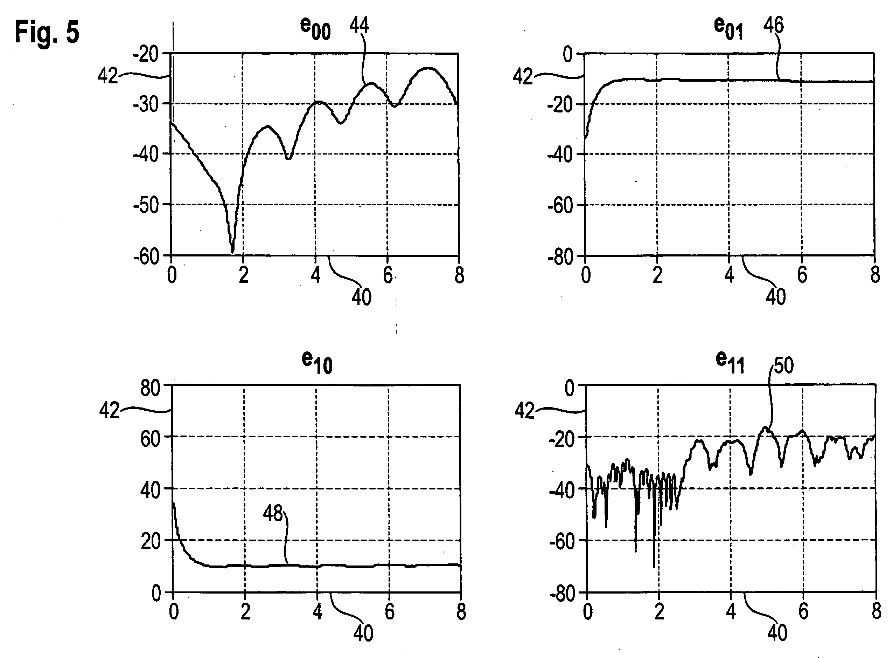

Das voranstehend erläuterte, erfindungsgemäße Verfahren zum Kalibrieren und Messen wird nachfolgend anhand von Messungen verifiziert. Als Koppler wird ein Aufbau aus zwei -10dB-Richtkopplern *Krytar Model 1821* verwendet. Ihr spezifizierter Frequenzbereich erstreckt sich von 1 bis 18 GHz. Durch Messungen bei niedrigeren Frequenzen kann somit ein Koppler mit hoher, frequenzabhängiger Koppeldämpfung emuliert werden. Zur Kalibrierung wird ein Netzwerkanalysator Rohde & Schwarz ZVA8 verwendet. Kalibrierdaten werden für den Frequenzbereich 300 kHz bis 8 GHz gewonnen. Die gewonnenen Koeffizienten der Fehlermatrix $E$ sind in Fig. 5 graphisch dargestellt, wobei jeweils auf einer horizontale Achse 40 eine Frequenz f in GHz und auf einer vertikalen Achse 42 jeweils Werte für den Koeffizienten $e_{xy}$ in dB aufgetragen sind. Ein erster Graph 44 veranschaulicht den Verlauf der Werte für den Koeffizienten $e_{00}$ in Abhängigkeit von der Frequenz f, ein zweiter Graph 46 veranschaulicht den Verlauf der Werte für den Koeffizienten $e_{01}$, in Abhängigkeit von der Frequenz f, ein dritter Graph 48 veranschaulicht den Verlauf der Werte für den Koeffizienten $e_{10}$ in Abhängigkeit von der Frequenz f und ein vierter Graph 50 veranschaulicht den Verlauf der Werte für den Koeffizienten $e_{11}$ in Abhängigkeit von der Frequenz f.

Die Koeffizienten $e_{01}$, und $e_{10}$ sind im Wesentlichen durch die Koppeldämpfung der Richtkoppler bestimmt. Diese weist beispielsweise bei 250 MHz einen Wert von ca. 19 dB auf. Erkennbar ist auch, dass mit diesem Aufbau prinzipbedingt keine Messung eines Gleichanteils möglich ist und dass die Bestimmung sehr niederfrequenter Anteile mit einer großen Unsicherheit behaftet sein wird. Aus diesem Grund werden diese Frequenzanteile in den nun gemessenen Signalen künstlich zu Null gesetzt. Bei der Messung im Zeitbereich wurde ein weiterer Eingangskanal des verwendeten Oszilloskops Agilent 54855A (Frequenzbereich bis 6 GHz) mit der Kalibrierebene 14 elektrisch verbunden, so dass eine direkte Messung der Spannung $v_M(t)$ in der Kalibrierebene zum Vergleich mit der mittels des erfindungsgemäßen Verfahrens bestimmten Spannung v(t) erfolgen kann. Mittels verschiedener HF-Generatoren bzw. Signalgeneratoren 24 werden unterschiedliche Signale in den Aufbau am ersten Tor 12 der elektrischen Signalleitung 10 eingespeist. Es werden jeweils Spannung v(t) und Strom i(t) in der Kalibrierebene 14, wie zuvor beschrieben, mit dem erfindungsgemäßen Verfahren bestimmt und mit der jeweiligen direkten Messung $v_M(t)$ verglichen.

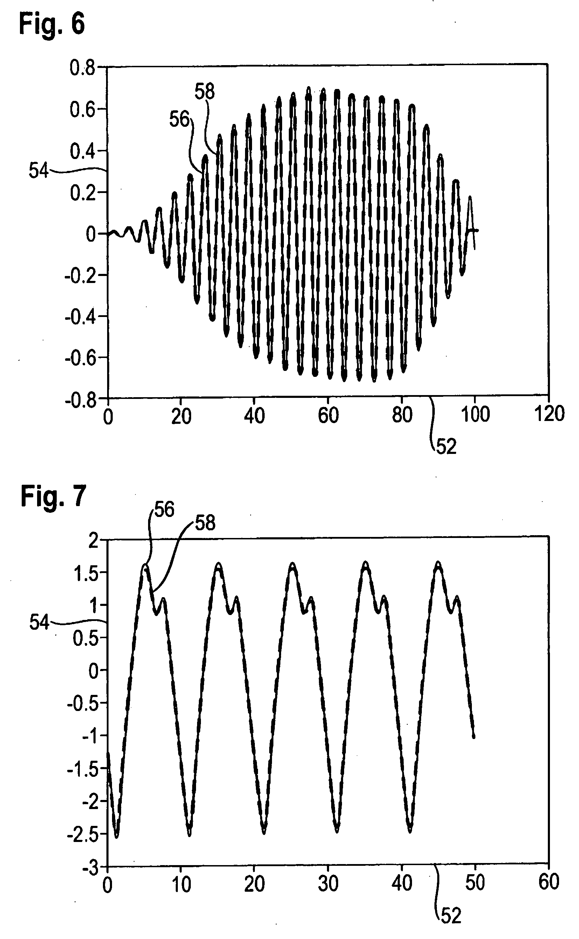

In den Fig. 6, 7 und 8 sind gemäß dem erfindungsgemäßen Verfahren bestimmte Spannungsverläufe v(t) jeweils der direkten Messung $v_M(t)$ als Referenz gegenübergestellt. Von besonderem Interesse sind aufgrund der Zeitbereichsmessung am ersten Tor 12 eingespeiste Testsignale, die nicht nur aus einer monofrequenten Schwingung konstanter Amplitude bestehen. Im Einzelnen handelt es sich bei den verwendeten Testsignalen um einen gepulsten Träger (f = 250 MHz), ein Signal mit einem hohen Gehalt an Oberwellen (Grundfrequenz 100 MHz) sowie um ein Rauschsignal.

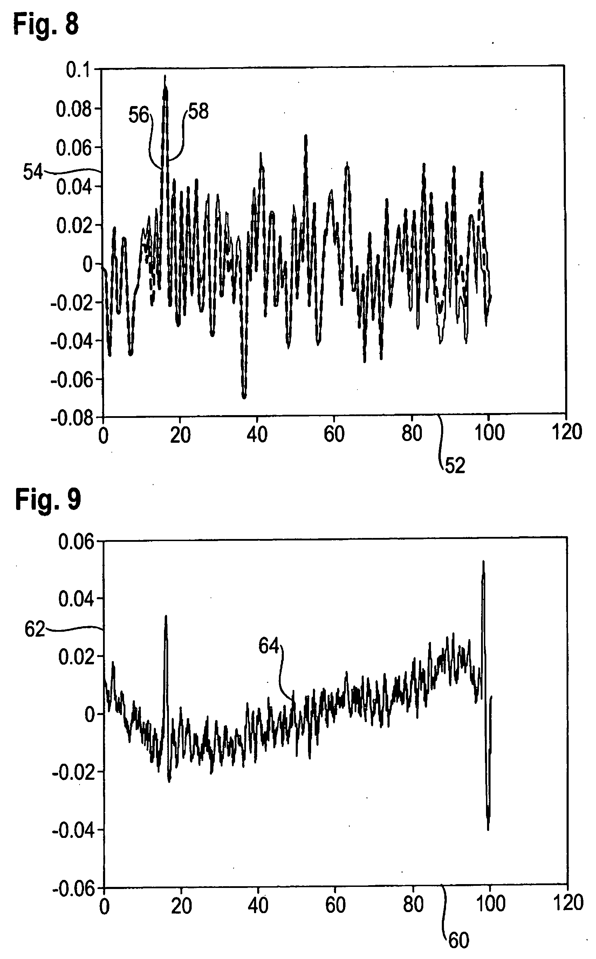

In den Fig. 6 bis 8 ist jeweils auf einer horizontalen Achse 52 eine Zeit t in ns (Nanosekunden) und auf einer vertikalen Achse 54 eine elektrische Spannung U in Volt aufgetragen. Ein fünfter Graph 56 mit durchgezogener Linie veranschaulicht jeweils das direkt gemessene Signal $v_M(t)$ der elektrischen Spannung in der Kalibrierebene 14 in Abhängigkeit von der Zeit t und ein sechster Graph 58 mit gestrichelter Linie veranschaulicht jeweils das mit dem erfindungsgemäßen Verfahren bestimmte Signal v(t) der elektrischen Spannung in der Kalibrierebene 14 in Abhängigkeit von der Zeit t. In Fig. 6 wurde als Testsignal der gepulsten Träger (f = 250 MHz) am ersten Tor 12 eingespeist, in Fig. 7 wurde als Testsignal das Signal mit einem hohen Gehalt an Oberwellen (Grundfrequenz 100 MHz) am ersten Tor 12 eingespeist und in Fig. 8 wurde als Testsignal das Rauschsignal am ersten Tor 12 eingespeist. Insgesamt zeigen die Testergebnisse, dass eine sehr gute Übereinstimmung zwischen den gemäß dem erfindungsgemäßen Verfahren bestimmten Spannungsverläufen v(t) und dem direkt gemessenen Spannungsverlauf $v_M(t)$ erzielt wird.

Nachfolgend werden die erkennbaren Abweichungen zwischen v(t) und $v_M(t)$ erläutert:

In Fig. 6 ist eine Abweichung zwischen v(t) 58 und $v_M(t)$ 56 am zeitlichen Ende des gemessenen Verlaufs erkennbar. Dies kann über die Eigenschaft der FFT erklärt werden, Eingangssignale als periodisch fortsetzbar zu betrachten. Diese Eigenschaft führt zu möglichen Fehlern am Beginn und am Ende des aufgezeichneten Signals, sofern dieses nicht periodisch fortsetzbar ist. Dieser Fehler kann z.B. durch Messung eines zeitlich längeren Segments kombiniert mit anschließender Fensterung umgangen werden.

Die Verläufe in Fig. 8 weisen stellenweise eine erkennbare Differenz auf. Diese Differenz $\Delta U$ ist in Fig. 9 graphisch dargestellt, wobei auf einer horizontalen Achse 60 die Zeit t in ns und auf einer vertikalen Achse 62 eine Spannungsdifferenz $\Delta U$ in Volt zwischen dem gemessenen Signal $v_M(t)$ 56 und dem mit dem erfindungsgemäßen Verfahren bestimmten Signal v(t) 58 aufgetragen ist. Ein siebter Graph 64 veranschaulicht den zeitlichen Verlauf der Spannungsdifferenz ΔU(t).

Neben der bereits erwähnten Abweichung am zeitlichen Ende und einem Fehler bei t = 16ns, der auf eine kurzfristige Übersteuerung des Referenzkanals zurückzuführen ist, weist die Differenz einen sinusförmigen Verlauf mit einer Periodizität von ca. 100 ns entsprechend $f \approx 10MHz$ auf. Es ist davon auszugehen, dass die Messung bei dieser Frequenz aufgrund der sehr hohen Koppeldämpfung mit einem vergleichsweise großen Messfehler versehen ist.

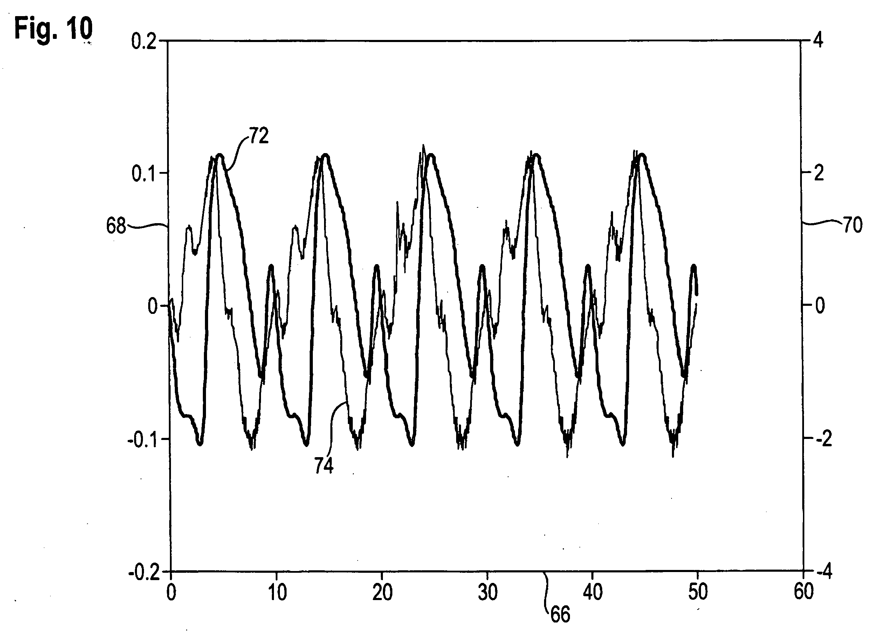

In Fig. 10 ist auf einer horizontalen Achse 66 eine Zeit t in ns auf einer vertikalen Achse 68 Werte für gemessene Rohspannungen $v_1$ am ersten Ausgang 20 des Richtkopplers 18 in Volt und auf einer weiteren vertikalen Achse 70 Werte für gemessenen Rohspannungen $v_2$ am zweiten Ausgang 22 des Richtkopplers in Volt aufgetragen. Ein achter Graph 72 zeigt den Verlauf der Rohspannung $v_1(t)$ über die Zeit und ein neunter Graph 74 zeigt den Verlauf der Rohspannung $v_2(t)$ über die Zeit.

Die rohen Spannungen $v_1(t)$ 72 und $v_2(t)$ 74 liegen an den Eingängen 36, 38 des Oszilloskops 34 für den Fall des oberwellenhaltigen Testsignals (vgl. Fig. 7) an. Es ist erkennbar, dass der Frequenz- und Phasengang des Richtkopplers 18 zu einer starken Verzerrung der Signale führt. Mit dem beschriebenen, erfindungsgemäßen Verfahren mit der speziellen Kombination aus Kalibrier-, Mess- und Berechnungsmethode ist es nun möglich, das ursprüngliche Signal v(t) 58 aus den gemessenen Signalen $v_1(t)$ 72 und $v_2(t)$ 74 zu rekonstruieren.

**Patentansprüche**

1. Verfahren zum Bestimmen von elektrischer Spannung u(t) und/oder elektrischem Strom i(t) eines HF-Signals im Zeitbereich auf einer elektrischen Leitung in einer Kalibrierebene (14), wobei die Kalibrierebene (14) derart ausgebildet ist, dass an der Kalibrierebene (14) ein Messobjekt (16) elektrisch verbindbar ist, wobei mit mindestens einem Richtkoppler (18) mit zwei Ausgängen (20, 22) und einem Signaleingang (19) ein Anteil eines ersten HF-Signals, welches innerhalb des Richtkopplers (18) von dessen Signaleingang (19) in Richtung der Kalibrierebene (14) läuft, und ein Anteil eines zweiten HF-Signals, welches innerhalb des Richtkopplers (18) von der Kalibrierebene (14) in Richtung des Signaleingangs (19) läuft, ausgekoppelt wird, wobei an einem ersten Ausgang (20) des Richtkopplers (18) eine zeitvariable erste Signalgröße $v_1(t)$ (72) des Anteils des ersten HF-Signals und an einem zweiten Ausgang (22) des Richtkopplers (18) eine zeitvariable zweite Signalgröße $v_2(t)$ (74) des Anteils des zweiten HF-Signals erfasst wird, wobei der Richtkoppler (18) an seinem Signaleingang (19) mit einer Zuleitung (10) verbunden ist, wobei die Zuleitung (10) an ihrem anderen Ende ein erstes Tor (12) aufweist, wobei für ein Fehlerzweitor des Richtkopplers (18) mit einer ersten Fehlermatrix $E$

$$E = \begin{pmatrix} e_{00} & e_{01} \\ e_{10} & e_{11} \end{pmatrix}$$

die ersten Fehlerterme $e_{00}$, $e_{01}$, $e_{10}$ und $e_{11}$ in einem ersten Schritt (Kalibrierschritt) in Abhängigkeit von einer Frequenz f bestimmt werden und daraufhin in einem zweiten Schritt (Messschritt) die zeitvariable erste Signalgröße $v_1(t)$ und die zeitvariable zweite Signalgröße $v_2(t)$ mit einer ersten mathematischen Operation in den Frequenzraum als Wellengrößen $V_1(f)$ und $V_2(f)$ überführt werden, wobei aus den Wellengrößen $V_1(f)$ und $V_2(f)$ mittels der ersten Fehlerterme $e_{00}$, $e_{01}$, $e_{10}$ und $e_{11}$ absolute Wellengrößen $a_1$ und $b_1$ im Frequenzraum in der Kalibrierebene (14) berechnet werden, wobei die berechneten absoluten Wellengrößen $a_1$ und $b_1$ mittels einer zweiten mathematischen Operation in die elektrische Spannung u(t) und/oder den elektrischen Strom i(t) des HF-Signals im Zeitbereich an der Kalibrierebene (14) umgerechnet werden,
wobei
zur Bestimmung der ersten Fehlerterme $e_{00}$, $e_{01}$, $e_{10}$ und $e_{11}$ jeweils das erste Tor (12), der Signaleingang (19) des Richtkopplers (18) samt Zuleitung (10), der erste Ausgang (20) des Richtkopplers (18) und der zweite Ausgang (22) des Richtkopplers (18) mit einer Kalibriervorrichtung (26) elektrisch verbunden werden und dass zum Messen der zeitvariablen ersten Signalgröße $v_1(t)$ und der zeitvariablen zweiten Signalgröße $v_2(t)$ jeweils der Signaleingang (19), der erste Ausgang (20) des Richtkopplers und der zweite Ausgang (22) des Richtkopplers von der Kalibriervorrichtung (26) getrennt und mit einer Zeitbereichsmessvorrichtung (34) elektrisch verbunden werden, wobei als Kalibriervorrichtung (26) ein VNA (Vektorieller Netzwerk Analysator) mit einem ersten VNA-Tor (28), einem zweiten VNA-Tor (30) und einem dritten VNA-Tor (32) verwendet wird, wobei eine über den ersten Ausgang (20) des Richtkopplers (18) ausgekoppelte Wellengröße $a_2$ des Anteils des ersten HF-Signals an dem mit dem ersten Ausgang (20) elektrisch verbundenen zweiten VNA-Tor (30) und eine über den zweiten Ausgang (22) des Richtkopplers (18) ausgekoppelte Wellengröße $b_2$ des Anteils des zweiten HF-Signals an dem mit dem zweiten Ausgang (22) elektrisch verbundenen dritten VNA-Tor (32) des Netzwerkanalysators (26) gemessen werden,

wobei für ein Fehlerzweitor zwischen dem ersten Tor (12) der Zuleitung (10), welches mit dem ersten Tor (28) des VNA (26) verbunden ist, und der Kalibrierebene (14) mit einer zweiten Fehlermatrix $I$

$$I = \begin{pmatrix} i_{00} & i_{01} \\ i_{10} & i_{11} \end{pmatrix},$$

die zweiten Fehlerterme $i_{00}$, $i_{01} \cdot i_{10}$ und $i_{11}$ bestimmt und aus diesen die ersten Fehlerterme $e_{00}$, $e_{01}$, $e_{10}$ und $e_{11}$ bestimmt werden,

wobei die ersten Fehlerterme $e_{00}$, $e_{01} \cdot e_{10}$ und $e_{11}$ sowie die Fehlerterme zweiten $i_{00}$, $i_{01} \cdot i_{10}$ und $i_{11}$ aus Streuparametern $S_{11,K}$, $S_{21,K}$ und $S_{31,K}/S_{21,K}$ einer Streumatrix $S$ für das erste Tor (12) der elektrischen Zuleitung (10) zum Signaleingang (19) des Richtkopplers (18), den ersten Ausgang (20) des Richtkopplers (18) und den zweiten Ausgang (22) des Richtkopplers (18) und jeweils einem an der Kalibrierebene (14) elektrisch angeschlossenen Kalibrierstandard K (16), wobei K gleich O, S oder M und jeweils für einen Kalibrierstandard (16) vom Typ Open (O), Short (S) oder Match (M) steht, gemäß den Formeln

$$i_{00} = S_{11,M}, \tag{4}$$

$$e_{00} = \frac{S_{31,M}}{S_{21,M}}, \tag{5}$$

$$i_{10} \cdot i_{01} = \frac{(\Gamma_O - \Gamma_S)(S_{11,O} - S_{11,M})(S_{11,S} - S_{11,M})}{\Gamma_O \Gamma_S (S_{11,O} - S_{11,S})} \tag{6}$$

$$e_{10} \cdot e_{01} = \frac{(\Gamma_O - \Gamma_S)\left(\frac{S_{31,O}}{S_{21,O}} - \frac{S_{31,M}}{S_{21,M}}\right)\left(\frac{S_{31,S}}{S_{21,S}} - \frac{S_{31,M}}{S_{21,M}}\right)}{\Gamma_O \Gamma_S \left(\frac{S_{31,O}}{S_{21,O}} - \frac{S_{31,S}}{S_{21,S}}\right)} \tag{7}$$

$$i_{11} = \frac{\Gamma_S(S_{11,O} - S_{11,M}) - \Gamma_O(S_{11,S} - S_{11,M})}{\Gamma_O \Gamma_S (S_{11,O} - S_{11,S})} \tag{8}$$

$$e_{11} = \frac{\Gamma_S\left(\frac{S_{31,O}}{S_{21,O}} - \frac{S_{31,M}}{S_{21,M}}\right) - \Gamma_O\left(\frac{S_{31,S}}{S_{21,S}} - \frac{S_{31,M}}{S_{21,M}}\right)}{\Gamma_O \Gamma_S \left(\frac{S_{31,O}}{S_{21,O}} - \frac{S_{31,S}}{S_{21,S}}\right)} \tag{9}$$

berechnet werden, wobei $\Gamma_O$ ein bekannter Reflexionsfaktor des Kalibrierstandards (16) Open und $\Gamma_S$ ein bekannter Reflexionsfaktor des Kalibrierstandards (16) Short ist, wobei die Streuparameter $S_{11,K}$, $S_{21,K}$ und $S_{31,K}/S_{21,K}$ gemäß den Formeln

$$S_{11,K} = \frac{b_0}{a_0} \tag{1}$$

$$S_{21,K} = \frac{a_2}{a_0} \tag{2}$$

$$\frac{S_{31,K}}{S_{21,K}} = \frac{b_2}{a_2} \tag{3}$$

aus Messungen mit dem VNA (26) von einer Wellengröße $a_0$ des ersten HF-Signals am ersten Tor (12), einer

Weitengröße $b_0$ des zweiten HF-Signals am ersten Tor (12), der Wellengröße $a_2$ des Anteils des ersten HF-Signals am ersten Ausgang (20) des Richtkopplers (18) und der Wellengröße $b_2$ des Anteils des zweiten HF-Signals am zweiten Ausgang (22) des Richtkopplers (18) bestimmt werden, wobei jeweils der Kalibrierstandard K (16) an der Kalibrierebene (14) elektrisch angeschlossen ist,

wobei die Wellengrößen $a_1$ ,und $b_1$ gemäß folgender Formeln bestimmt werden

$$a_1 = \frac{e_{10}a_2}{1 - e_{11}\Gamma_{DUT}} \qquad (13)$$

$$b_1 = \frac{b_2 - e_{00}a_2}{e_{01}} \qquad (15)$$

wobei

$$a_2 = \frac{V_1(f)}{\sqrt{Z_1}} \qquad (18)$$

$$b_2 = \frac{V_2(f)}{\sqrt{Z_1}} \qquad (19)$$

$$\Gamma_{DUT} = \frac{\frac{b_2}{a_2} - e_{00}}{e_{10} \cdot e_{01} + e_{11}\left(\frac{b_2}{a_2} - e_{00}\right)} \cdot \qquad (10)$$

$$e_{10} = i_{10} \cdot \frac{a_0}{a_2} \cdot \frac{1 - e_{11}\Gamma_{DUT}}{1 - i_{11}\Gamma_{DUT}} \qquad (14)$$

ist, wobei $\Gamma_{DUT}$ der Reflexionsfaktor des an der Kalibrierebene (14) angeschlossenen, zu testenden Prüflings (16) (DUT - Device Under Test) und $Z_1$ die Impedanz am ersten und zweiten Ausgang (20, 22) des Richtkopplers (18) ist.

2. Verfahren nach Anspruch 1, **dadurch gekennzeichnet, dass** die erste signalgröße $v_1(t)$ (72) und die zweite signalgröße $v_2(t)$ (74) jeweils eine elektrische Spannung oder ein elektrischer Strom sind.

3. Verfahren nach Anspruch 1 oder 2, **dadurch gekennzeichnet, dass** die erste mathematische Operation eine FFT ist (Fast Fourier Transformation) gemäß

$$\{V_1(l \cdot \Delta f)\} = FFT\{v_1(k \cdot \Delta t)\} \qquad (16)$$

$$\{V_2(l \cdot \Delta f)\} = FFT\{v_2(k \cdot \Delta t)\} \qquad (17)$$

mit $k = 0,1,...,N\text{-}1$ *und* $l = 0,1,...,\frac{N-1}{2}$, wobei N eine Anzahl von Datenpunkten ist, wobei $\Delta f$ eine Frequenz-schrittweite mit $\Delta f = 2f_{max}/(N - 1)$ ist, wobei $\Delta t$ eine zeitlichen Schrittweite mit $\Delta t = 0,5/f_{max}$ ist, wobei $f_{max}$ die maximale Frequenz bezeichnet, für die Kalibrierdaten vorliegen, wobei die zweite mathematische Operation eine inverse FFT (IFFT - Inverse Fast Fourier Transformation) gemäß

$$\{u(k \cdot \Delta t)\} = IFFT\{\sqrt{Z_0}(a_1(l \cdot \Delta f) + b_1(l \cdot \Delta f))\}, \qquad (20)$$

$$\{i(k \cdot \Delta t)\} = IFFT\left\{\left(\sqrt{Z_0}\right)^{-1}\left(a_1(l \cdot \Delta f) - b_1(l \cdot \Delta f)\right)\right\}. \qquad (21)$$

ist, wobei $Z_0$ eine Impedanz in der Kalibrierebene ist.

**4.** Verfahren nach mindestens einem der Ansprüche 1 bis 3, **dadurch gekennzeichnet, dass** als Zeitbereichsmessvorrichtung (34) ein Oszilloskop verwendet wird.

## Claims

**1.** Method for determining electric voltage u(t) and/or electric current i(t) of an RF signal in the time domain in a calibration plane (14) on an electrical conductor, said calibration plane (14) being designed such that a device under test (16) can be connected electrically in the calibration plane (14), wherein, by means of at least one directional coupler (18) having two outputs (20, 22) and one signal input (19), a component of a first RF signal which runs within the directional coupler (18) from its signal input (19) in the direction of the calibration plane (14) and a component of a second RF signal which runs within the directional coupler (18) from the calibration plane (14) in the direction of the signal input (19) are coupled out, wherein a time-variable first signal value $v_1(t)$ (72) of the component of the first RF signal is measured at a first output (20) of the directional coupler (18) and a time-variable second signal value $v_2(t)$ (74) of the component of the second RF signal is measured at a second output (22) of the directional coupler (18), wherein the directional coupler (18) is connected at its signal input (19) with an input cable (10), said input cable (10) having at its other end a first port (12), wherein, for a two-port error of the directional coupler (18) with a first error matrix $E$

$$E = \begin{pmatrix} e_{00} & e_{01} \\ e_{10} & e_{11} \end{pmatrix}$$

the first error terms $e_{00}$, $e_{01}$, $e_{10}$ and $e_{11}$ are determined in a first step (calibration step) as a function of a frequency f and then, in a second step (measurement step), the time-variable first signal value $v_1(t)$ and the time-variable second signal value $v_2(t)$ are transformed, through a first mathematical operation, into the frequency domain as wave quantities $V_1(f)$ and $V_2(f)$, wherein absolute wave quantities $a_1$ and $b_1$ in the frequency domain in the calibration plane (14) are calculated from the wave quantities $V_1(f)$ and $V_2(f)$ by means of the first error terms $e_{00}$, $e_{01}$, $e_{10}$ and $e_{11}$, wherein the calculated absolute wave quantities $a_1$ and $b_1$ are converted by means of a second mathematical operation into the electric voltage u(t) and/or the electric current i(t) of the RF signal in the time domain in the calibration plane (14),
wherein,
in order to determine the first error terms $e_{00}$, $e_{01}$, $e_{10}$ and $e_{11}$, the first port (12), the signal input (19) of the directional coupler (18) together with input cable (10), the first output (20) of the directional coupler (18) and the second output (22) of the directional coupler (18) are each electrically connected with a calibration device (26) and, in order to measure the time-variable first signal value $v_1(t)$ and the time-variable second signal value $v_2(t)$, the signal input (19), the first output (20) of the directional coupler and the second output (22) of the directional coupler are isolated from the calibration device (26) and electrically connected with a time domain measuring device (34),
wherein a VNA (Vectorial Network Analyser) with a first VNA port (28), a second VNA port (30) and a third VNA port (32) is used as calibration device (26),
wherein a wave quantity $a_2$ of the component of the first RF signal coupled out via the first output (20) of the directional coupler (18) is measured at the second VNA port (30) electrically connected with the first output (20), and a wave quantity $b_2$ of the component of the second RF signal coupled out via the second output (22) of the directional coupler (18) is measured at the third VNA port (32) of the network analyser (26) electrically connected with the second output (22),
wherein, for a two-port error between the first port (12) of the input cable (10), which is connected with the first port (28) of the VNA (26), and the calibration plane (14), with a second error matrix $I$

$$I = \begin{pmatrix} i_{00} & i_{01} \\ i_{10} & i_{11} \end{pmatrix}$$

the second error terms $i_{00}$, $i_{01}$, $i_{10}$ and $i_{11}$ are determined and the first error terms $e_{00}$, $e_{01}$, $e_{10}$ and $e_{11}$ are determined from these,

whereby the first error terms $e_{00}$, $e_{01}$, $e_{10}$ and $e_{11}$ and the second error terms $i_{00}$, $i_{01}$, $i_{10}$ and $i_{11}$ are calculated from scattering parameters $S_{11,K}$, $S_{21,K}$, and $S_{31,K}/S_{21,K}$ of a scattering matrix $\boldsymbol{S}$ for the first port (12) of the electric input cable (10) leading to the signal input (19) of the directional coupler (18), the first output (20) of the directional coupler (18) and the second output (22) of the directional coupler (18) and a calibration standard K (16) in each case electrically connected to the calibration plane (14), where K is equal to O, S or M and stands, respectively, for a calibration standard (16) of the type Open (O), Short (S) or Match (M), according to the formulas

$$i_{00} = S_{11,M}, \tag{4}$$

$$e_{00} = \frac{S_{31,M}}{S_{21,M}}, \tag{5}$$

$$i_{10} \cdot i_{01} = \frac{(\Gamma_O - \Gamma_S)(S_{11,O} - S_{11,M})(S_{11,S} - S_{11,M})}{\Gamma_O\Gamma_S(S_{11,O} - S_{11,S})} \tag{6}$$

$$e_{10} \cdot e_{01} = \frac{(\Gamma_O - \Gamma_S)\left(\frac{S_{31,O}}{S_{21,O}} - \frac{S_{31,M}}{S_{21,M}}\right)\left(\frac{S_{31,S}}{S_{21,S}} - \frac{S_{31,M}}{S_{21,M}}\right)}{\Gamma_O\Gamma_S\left(\frac{S_{31,O}}{S_{21,O}} - \frac{S_{31,S}}{S_{21,S}}\right)} \tag{7}$$

$$i_{11} = \frac{\Gamma_S(S_{11,O} - S_{11,M}) - \Gamma_O(S_{11,S} - S_{11,M})}{\Gamma_O\Gamma_S(S_{11,O} - S_{11,S})} \tag{8}$$

$$e_{11} = \frac{\Gamma_S\left(\frac{S_{31,O}}{S_{21,O}} - \frac{S_{31,M}}{S_{21,M}}\right) - \Gamma_O\left(\frac{S_{31,S}}{S_{21,S}} - \frac{S_{31,M}}{S_{21,M}}\right)}{\Gamma_O\Gamma_S\left(\frac{S_{31,O}}{S_{21,O}} - \frac{S_{31,S}}{S_{21,S}}\right)} \tag{9}$$

where $\Gamma_O$ is a known reflection factor of the Open calibration standard (16) and $\Gamma_S$ is a known reflection factor of the Short calibration standard (16), whereby the scattering parameters $S_{11,K}$, $S_{21,K}$, and $S_{31,K}/S_{21,K}$ are determined, according to the formulas

$$S_{11,K} = \frac{b_0}{a_0} \tag{1}$$

$$S_{21,K} = \frac{a_2}{a_0} \tag{2}$$

$$\frac{S_{31,K}}{S_{21,K}} = \frac{b_2}{a_2} \tag{3}$$

from measurements, carried out with the VNA (26), of a wave quantity $a_0$ of the first RF signal at the first port (12), a wave quantity $b_0$ of the second RF signal at the first port (12), the wave quantity $a_2$ of the component of the first RF signal at the first output (20) of the directional coupler (18) and the wave quantity $b_2$ of the component of the second RF signal at the second output (22) of the directional coupler (18), wherein in each case the calibration standard K (16) is electrically connected to the calibration plane (14),

wherein the wave quantities $a_1$ and $b_1$ are determined according to the following formulas

$$a_1 = \frac{e_{10} a_2}{1 - e_{11} \Gamma_{DUT}} \qquad (13)$$

$$b_1 = \frac{b_2 - e_{00} a_2}{e_{01}} \qquad (15)$$

where

$$a_2 = \frac{V_1}{\sqrt{Z_1}} \qquad (18)$$

$$b_2 = \frac{V_2}{\sqrt{Z_1}} \qquad (19)$$

$$\Gamma_{DUT} = \frac{\frac{b_2}{a_2} - e_{00}}{e_{10} \cdot e_{01} + e_{11}\left(\frac{b_2}{a_2} - e_{00}\right)}. \qquad (10)$$

$$e_{10} = i_{10} \cdot \frac{a_0}{a_2} \cdot \frac{1 - e_{11} \Gamma_{DUT}}{1 - i_{11} \Gamma_{DUT}} \qquad (14)$$

where $\Gamma_{DUT}$ is the reflection factor of the device under test (16) (DUT) connected to the calibration plane (14) and $Z_1$ is the impedance at the first and second output (20, 22) of the directional coupler (18).

2. Method according to claim 1, **characterised in that** the first signal value $v_1(t)$ (72) and the second signal value $v_2(t)$ (74) are, respectively, an electric voltage or an electric current.

3. Method according to claim 1 or 2, **characterised in that** the first mathematical operation is an FFT (Fast Fourier Transform) according to

$$\{V_1(l \cdot \Delta f)\} = FFT\{v_1(k \cdot \Delta t)\} \qquad (16)$$

$$\{V_2(l \cdot \Delta f)\} = FFT\{v_2(k \cdot \Delta t)\} \qquad (17)$$

*mit k* = 0,1,..., *N* - 1 *und* $l = 0,1, \ldots, \frac{N-1}{2}$, where N is a number of data points, where $\Delta f$ is a frequency increment where $\Delta f = 2f_{max}/(N-1)$, where $\Delta t$ is a time increment where $\Delta t = 0.5/f_{max}$, where $f_{max}$ represents the maximum frequency for which calibration data are available, wherein the second mathematical operation is an inverse FFT (IFFT - Inverse Fast Fourier Transform) according to

$$\{u(k \cdot \Delta t)\} = IFFT\{\sqrt{Z_0}(a_1(l \cdot \Delta f) + b_1(l \cdot \Delta f))\}, \qquad (20)$$

$$\{i(k \cdot \Delta t)\} = IFFT\left\{\left(\sqrt{Z_0}\right)^{-1}(a_1(l \cdot \Delta f) - b_1(l \cdot \Delta f))\right\}. \qquad (21)$$

where $Z_0$ is an impedance in the calibration plane.

4. Method according to at least one of the claims 1 to 3, **characterised in that** an oscilloscope is used as time domain measuring device (34).

**Revendications**

1. Procédé pour déterminer une tension électrique u(t) et/ou un courant électrique i(t) d'un signal HF dans le domaine temporel sur une ligne électrique dans un plan de calibrage (14), dans lequel le plan de calibrage (14) est réalisé de telle façon qu'un objet à mesurer (16) est susceptible d'être connecté électriquement au plan de calibrage (14), dans lequel, avec au moins un coupleur directionnel (18) avec deux sorties (20, 22) et avec une entrée de signal (19), une part d'un premier signal HF qui circule à l'intérieur du coupleur directionnel (18) depuis son entrée de signal (19) en direction du plan de calibrage (14), et une part d'un second signal HF qui circule à l'intérieur du coupleur directionnel (18) depuis le plan de calibrage (14) en direction de l'entrée de signal (19), sont découplées, et dans lequel on détecte à une première sortie (20) du coupleur directionnel (18) une première grandeur de signal $v_1(t)$ (72) variable dans le temps de la part du premier signal HF et on détecte à une seconde sortie (22) du coupleur directionnel (18) une seconde grandeur de signal $v_2(t)$ (74) variable dans le temps de la part du second signal HF, dans lequel le coupleur directionnel (18) est connecté à son entrée de signal (19) avec une ligne d'arrivée (10), dans lequel la ligne d'arrivée (10) comprend à son autre extrémité une première porte (12), dans lequel, pour une double porte d'erreur du coupleur directionnel (18) on détermine en une première étape (étape de calibrage) et en fonction d'une fréquence f les premiers termes d'erreur $e_{00}$, $e_{01}$, $e_{10}$ et $e_{11}$ avec une première matrice d'erreur E

$$E = \begin{pmatrix} e_{00} & e_{01} \\ e_{10} & e_{11} \end{pmatrix}$$

et suite à cela on convertit dans une seconde étape (étape de mesure) la première grandeur de signal variable dans le temps $v_1(t)$ et la seconde grandeur de signal variable dans le temps $v_2(t)$ avec une première opération mathématique dans le domaine de fréquences à titre de grandeurs d'onde $V_1(f)$ et $V_2(f)$, dans lequel on calcule à partir des grandeurs d'onde $V_1(f)$ et $V_2(f)$ au moyen des premiers termes d'erreur $e_{00}$, $e_{01}$, $e_{10}$ et $e_{11}$ des grandeurs d'onde absolues $a_1$ et $b_1$ dans le domaine de fréquences dans le plan de calibrage (14), dans lequel les grandeurs d'onde absolues calculées $a_1$ et $b_1$ sont recalculées au moyen d'une seconde opération mathématique dans la tension électrique u(t) et/ou dans le courant électrique i(t) du signal HF dans le domaine temporel au niveau du plan de calibrage (14),
dans lequel pour la détermination des premiers termes d'erreur $e_{00}$, $e_{01}$, $e_{10}$ et $e_{11}$ on connecte électriquement respectivement la première porte (12) de l'entrée de signal (19) du coupleur directionnel (18) ensemble avec la ligne d'arrivée (10), la première sortie (20) du coupleur directionnel (18) et la seconde sortie (22) du coupleur directionnel (18) avec un dispositif de calibrage (26), et pour mesurer la première grandeur de signal variable dans le temps $v_1(t)$ et la seconde grandeur de signal variable dans le temps $v_2(t)$ on déconnecte électriquement respectivement l'entrée de signal (19), la première sortie (20) du coupleur directionnel et la seconde sortie (22) du coupleur directionnel vis-à-vis du dispositif de calibrage (26), et on les connecte respectivement électriquement à un dispositif de mesure en domaine temporel (34),
dans lequel on utilise à titre de dispositif de calibrage (26) un ARV (analyseur de réseau vectoriel) avec une première porte ARV (28), une seconde porte ARV (30) et une troisième porte ARV (32),
dans lequel on mesure au niveau de la seconde porte ARV (30), de l'analyseur de réseau (26), connectée électriquement avec la première sortie (20), une grandeur d'onde $a_2$, découplée via la première sortie (20) du coupleur directionnel (18), de la part du premier signal HF, et on mesure au niveau de la troisième porte ARV (32), de l'analyseur de réseau (26), connectée électriquement avec la seconde sortie (22), une grandeur d'onde $b_2$, découplée via la seconde sortie (22) du coupleur directionnel (18), de la part du second signal HF,
dans lequel, pour une double porte d'erreur entre la première porte (12) de la ligne d'arrivée (10), porte qui est connectée avec la première porte (28) de l'analyseur de réseau (26), et le plan de calibrage (14), on calcule avec une deuxième matrice d'erreur I

$$I = \begin{pmatrix} i_{00} & i_{01} \\ i_{10} & i_{11} \end{pmatrix},$$

les seconds termes d'erreur $i_{00}$, $i_{01}$, $i_{10}$ et $i_{11}$ et on détermine à partir de ceux-ci les premiers termes d'erreur $e_{00}$, $e_{01}$, $e_{10}$ et $e_{11}$,
dans lequel les premiers termes d'erreur $e_{00}$, $e_{01}$, $e_{10}$ et $e_{11}$ ainsi que les seconds termes d'erreur $i_{00}$, $i_{01}$, $i_{10}$ et $i_{11}$

sont calculés à partir des paramètres de dispersion $S_{11,K}$, $S_{21,K}$ et $S_{31,K}/S_{21,K}$ d'une matrice de dispersion S pour la première porte (12) de la ligne d'amenée électrique (10) à l'entrée de signal (19) du coupleur directionnel (18), pour la première sortie (20) du coupleur directionnel (18) et pour la seconde sortie (22) du coupleur directionnel (18), et à partir d'un standard de calibrage respectif K (16) raccordé électriquement au plan de calibrage (14), dans lequel K est égal à O, S ou M et signifie respectivement un standard de calibrage (16) du type ouvert (O), en court-circuit (S) ou en accord (M), d'après les formules

$$i_{00} = S_{11,M}, \tag{4}$$

$$e_{00} = \frac{S_{32,M}}{S_{22,M}}, \tag{5}$$

$$i_{10} \cdot i_{01} = \frac{(\Gamma_O - \Gamma_S)(S_{11,O} - S_{11,M})(S_{11,S} - S_{11,M})}{\Gamma_O \Gamma_S (S_{11,O} - S_{11,S})} \tag{6}$$

$$e_{10} \cdot e_{01} = \frac{(\Gamma_O - \Gamma_S)\left(\frac{S_{31,O}}{S_{22,O}} - \frac{S_{31,M}}{S_{22,M}}\right)\left(\frac{S_{31,S}}{S_{22,S}} - \frac{S_{31,M}}{S_{22,M}}\right)}{\Gamma_O \Gamma_S \left(\frac{S_{32,O}}{S_{22,O}} - \frac{S_{31,S}}{S_{22,S}}\right)} \tag{7}$$

$$i_{11} = \frac{\Gamma_S (S_{11,O} - S_{11,M}) - \Gamma_O (S_{11,S} - S_{11,M})}{\Gamma_O \Gamma_S (S_{11,O} - S_{11,S})} \tag{8}$$

$$e_{11} = \frac{\Gamma_S \left(\frac{S_{31,O}}{S_{21,O}} - \frac{S_{31,M}}{S_{21,M}}\right) - \Gamma_O \left(\frac{S_{31,S}}{S_{21,S}} - \frac{S_{31,M}}{S_{21,M}}\right)}{\Gamma_O \Gamma_S \left(\frac{S_{31,O}}{S_{22,O}} - \frac{S_{31,S}}{S_{22,S}}\right)} \tag{9}$$

dans lesquelles $\Gamma_O$ est un facteur de réflexion connu du standard de calibrage (16) ouvert et $\Gamma_S$ et un facteur de réflexion connu du standard de calibrage (16) en court-circuit,

dans lesquelles les paramètres de dispersion $S_{11,K}$, $S_{21,K}$ et $S_{31,K}/S_{21,K}$ sont déterminés d'après les formules

$$S_{11,K} = \frac{b_0}{a_0} \tag{1}$$

$$S_{21,K} = \frac{a_2}{a_0} \tag{2}$$

$$\frac{S_{31,K}}{S_{21,K}} = \frac{b_2}{a_2} \tag{3}$$

à partir de mesures avec l'analyseur de réseau vectoriel (26) depuis une grandeur d'onde $a_0$ du premier signal HF à la première porte (12), d'une grandeur d'onde $b_0$ du second signal HF à la première porte (12), de la grandeur d'onde $a_2$ de la part du premier signal HF à la première sortie (20) du coupleur directionnel (18), et de la grandeur d'onde $b_2$ de la part du second signal HF à la seconde sortie (22) du coupleur directionnel (18), et de sorte que le standard de calibrage respectif K (16) est branché électriquement au plan de calibrage (14),

dans lesquelles les grandeurs d'onde $a_1$ et $b_1$ sont déterminées d'après les formules suivantes

$$a_1 = \frac{s_{10} \, a_2}{1 - s_{11} \Gamma_{DUT}} \tag{13}$$

$$b_1 = \frac{b_2 - s_{00}\, a_2}{s_{01}} \qquad\qquad (15)$$

avec

$$a_2 = \frac{V_2(f)}{\sqrt{Z_1}} \qquad\qquad (18)$$

$$b_2 = \frac{V_2(f)}{\sqrt{Z_1}} \qquad\qquad (19)$$

$$\Gamma_{DUT} = \frac{\frac{b_2}{a_2} - s_{00}}{s_{10}\cdot s_{01} + s_{11}\left(\frac{b_2}{a_2} - s_{00}\right)}. \qquad\qquad (10)$$

$$e_{10} = i_{10}\cdot\frac{a_0}{a_1}\cdot\frac{1 - s_{11}\Gamma_{DUT}}{1 - i_{11}\Gamma_{DUT}} \qquad\qquad (14)$$

où $\Gamma_{DUT}$ est le facteur de réflexion du dispositif contrôlé (16) à tester branché au plan de calibrage (14) (DUT = Device Under Test) et $Z_1$ est l'impédance à la première et à la seconde sortie (20, 22) du coupleur directionnel (18).

2. Procédé selon la revendication 1, **caractérisé en ce que** la première grandeur de signal $v_1(t)$ (72) et la seconde grandeur de signal $v_2(t)$ (74) sont respectivement une tension électrique ou un courant électrique.

3. Procédé selon la revendication 1 ou 2, **caractérisé en ce que** la première opération mathématique est une transformation rapide de Fourier d'après

$$\{V_1(l\cdot\Delta f)\} = FFT\{v_1(k\cdot\Delta t)\} \qquad\qquad (16)$$

$$\{V_2(l\cdot\Delta f)\} = FFT\{v_2(k\cdot\Delta t)\} \qquad\qquad (17)$$

*avec k* = 0,1,... *N* - 1

et $l = 0,1,\ldots,\frac{N-1}{2}$, dans lesquelles N est un nombre de points de données, $\Delta f$ est un incrément de fréquence avec $\Delta f = 2f_{max}/(N-1)$, où $\Delta t$ est un incrément temporel tel que $\Delta t = 0{,}5/f_{max}$, $f_{max}$ désignant la fréquence maximale pour laquelle il existe des données de calibrage, et la seconde opération mathématique est une transformation rapide inverse de Fourier d'après

$$\{u(k\cdot\Delta t)\} = IFFT\{\sqrt{Z_0}(a_1(l\cdot\Delta f) + b_1(l\cdot\Delta f))\}, \qquad\qquad (20)$$

$$\{i(k\cdot\Delta t)\} = IFFT\left\{\left(\sqrt{Z_0}\right)^{-1}(a_1(l\cdot\Delta f) - b_1(l\cdot\Delta f))\right\} \qquad\qquad (21)$$

dans lesquelles $Z_0$ est une impédance dans le plan de calibrage.

4. Procédé selon l'une au moins des revendications 1 à 3, **caractérisé en ce que** l'on utilise un oscilloscope à titre de dispositif de mesure en domaine temporel (34).

EP 2 831 613 B1

**Fig. 1**

**Fig. 2**

**Fig. 3**

Fig. 4

Fig. 5

**Fig. 6**

**Fig. 7**

**Fig. 8**

**Fig. 9**

**Fig. 10**

EP 2 831 613 B1

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- WO 03048791 A2

**In der Beschreibung aufgeführte Nicht-Patentliteratur**

- **UWE SIART.** *Kalibrierung von Netzwerkanalysatoren,* 04. Januar 2012, http://www.siart.de/lehre/nwa.pdf
- **D. ROOT et al.** X-Parameter: Das neue Paradigma zur Beschreibung nichtlinearer HF- und Mikrowellenbauelemente. *tm - Technisches Messen Nr. 7-8,* 2010, vol. 77
- **EL-DEEB W.S. et al.** Thru-less calibration algorithm and measurement system for on-wafer large-signal characterisation of microwave devices. *IET MICROWAVES ANTENNAS & PROPAGATION,* 18. November 2010, vol. 4 (11), 1773-1781
- **HU J. et al.** Calibrated non-linear vector network measurement without using a multi-harmonic generator. *IET MICROWAVES ANTENNAS & PROPAGATION,* 11. April 2011, vol. 5 (5), 616-624
- **HIEBEL, MICHAEL.** Grundlagen der vektoriellen Netzwerkanalyse. Rohde & Schwarz GmbH & Co. KG, 2006
- **MICHAEL HIEBEL.** Grundlagen der vektoriellen Netzwerkanalyse. Rohde & Schwarz GmbH & Co. KG, 2006